# EUROPÄISCHE PATENTSCHRIFT

(11) **EP 2 805 412 B1**
(45) Veröffentlichungstag und Bekanntmachung des Hinweises auf die Patenterteilung: **13.01.2016**
(21) Anmeldenummer: 13700684.7
(22) Anmeldetag: 14.01.2013
(51) Int. Cl.: H03F 3/185, H03F 3/217, H03F 1/30

(54) **VERSTÄRKERVORRICHTUNG SOWIE VERFAHREN ZUM AKTIVIEREN EINER ODER DER VERSTÄRKERVORRICHTUNG**
AMPLIFIER DEVICE AND METHOD FOR ACTIVATING AN AMPLIFIER DEVICE OR THE AMPLIFIER DEVICE
DISPOSITIF AMPLIFICATEUR AINSI QUE PROCÉDÉ PERMETTANT D'ACTIVER UN OU LE DISPOSITIF AMPLIFICATEUR

(30) Priorität: 16.01.2012 DE 102012200524
(43) Veröffentlichungstag der Anmeldung: 26.11.2014
(73) Patentinhaber: Robert Bosch GmbH, 70442 Stuttgart (DE)
(72) Erfinder: HOFFMEISTER, Fabian, 84337 Schoenau (DE)
(86) Internationale Anmeldenummer: PCT/EP2013/050559
(87) Internationale Veröffentlichungsnummer: WO 2013/107708

(56) Entgegenhaltungen:
- EP-A1- 1 659 569
- US-A- 5 953 049
- US-A1- 2005 019 020
- US-A1- 2006 012 710
- US-A1- 2006 284 673
- US-A1- 2006 290 810
- US-B1- 6 931 373

## Beschreibung

### Stand der Technik

Die Erfindung betrifft eine Verstärkervorrichtung mit einer Steuerungseinrichtung, wobei die Steuerungseinrichtung eine Eingangsschnittstelle für ein Audiosignal aufweist, und mit einer der Steuerungseinrichtung nachgeschalteten Verstärkereinrichtung zur Verstärkung des Audiosignals.

Verstärkeranlagen werden in vielen Bereichen verwendet So werden diese beispielsweise in Kleinstanlagen, wie zum Beispiel Handys oder Smartphones, in mittleren Anlagen, wie zum Beispiel Heimmusikanlagen oder Fernseher, oder auch in Großanlagen, wie zum Beispiel Public-Address-Anlagen oder PA-Anlagen, eingesetzt.

Unter den Verstärkerarten sind sogenannte Klasse-D-Verstärker bekannt, welche ein analoges Signal zunächst mit einem Pulsweitenmodulator in ein pulsweitenmoduliertes Schaltsignal umwandeln, das dann verstärkt und nachfolgend über einen Filter wieder in eine sich stetig veränderliche Spannung zurückgewandelt wird. Diese Art der Verstärker sind besonders energieeffizient und werden daher bevorzugt bei Verstärkern mit hohen Leistungen eingesetzt.

Die Druckschrift DE102008040291A1 offenbart einen derartigen Klasse-D-Verstärker.

Aus der EP 1 659 569 A1 ist eine Vorrichtung und ein Programm zur Verarbeitung von Audiosignalen mit einer Verzögerungssektion zur Verzögerung des Audiosignals bekannt.

### Offenbarung der Erfindung

Im Rahmen der Erfindung wird eine Verstärkervorrichtung mit den Merkmalen des Anspruchs 1, ein Verfahren zum Aktivieren einer oder der Verstärkervorrichtung mit den Merkmalen des Anspruchs 10 sowie eine Steuerungseinrichtung mit den Merkmalen des Anspruchs 11 offenbart. Bevorzugte oder vorteilhafte Ausführungsformen der Erfindung ergeben sich aus den Unteransprüchen, der nachfolgenden Beschreibung sowie den beigefügten Figuren.

Die Erfindung betrifft eine Verstärkervorrichtung, welche zur Verstärkung eines Audiosignals ausgebildet ist. Die Verstärkervorrichtung kann beispielsweise in Musikanlagen oder - bevorzugt - in Beschallungsanlagen, insbesondere bei Public-Address-Systemen zur Beschallung von komplexen Bereichen eingesetzt werden. Beispielsweise kann die Verstärkervorrichtung zur Beschallung eines Fußballstadions, eines Theaters, einer Schule etc. eingesetzt werden. Das Audiosignal ist beispielsweise als ein analoges Signal ausgebildet, welches von einem Mikrofon oder einer anderen Audioquelle stammt.

Die Verstärkervorrichtung umfasst eine Steuerungseinrichtung, wobei die Steuerungseinrichtung eine Eingangsschnittstelle für das Audiosignal aufweist. Über die Steuerungseinrichtung wird somit das Audiosignal in die Verstärkervorrichtung eingeführt. Die Steuerungseinrichtung kann als eine kompakte oder zentrale Baueinheit oder bei abgewandelten Ausführungsformen - auch z. B. in Funktionen aufgeteilt - in der Verstärkervorrichtung dezentral verteilt sein.

Der Steuerungseinrichtung ist eine Verstärkereinrichtung nachgeschaltet, welche zur Verstärkung des Audiosignals ausgebildet ist.

Im Rahmen der Erfindung wird vorgeschlagen, dass die Steuerungseinrichtung ein Verzögerungsmodul aufweist, wobei das Verzögerungsmodul ausgebildet ist, das Audiosignal um einen Verzögerungswert verzögert an die Verstärkereinrichtung weiterzugeben und in einer Anpassungsphase den Verzögerungswert automatisch und/oder selbsttätig von einem Startwert zu einem Endwert zu verringern.

Das Verzögerungsmodul dient somit dazu, das Audiosignal um den Verzögerungswert zeitlich zu verzögern, insbesondere zwischenzuspeichern, und erst nach Ablauf des Verzögerungswertes an die Verstärkereinrichtung weiterzugeben. Der Verzögerungswert wird von dem Verzögerungsmodul von einem Startwert zu einem Endwert verringert oder abgebaut.

Es ist ein Vorteil der Erfindung, dass durch das Verzögerungsmodul zum einen eine Verzögerung des Audiosignals ermöglicht wird und zum anderen eine Möglichkeit geschaffen ist, diese Verzögerung in einer Anpassungsphase wieder zu verringern beziehungsweise sogar auf den Endwert Null zurückzuführen. Es ist dabei eine Überlegung, dass es aus schaltungstechnischen Gründen notwendig sein kann, dass ein Audiosignal nicht sofort und/oder unverzögert an die Verstärkereinrichtung weitergegeben wird, sondern erst nach einer Verzögerung. Beispielsweise kann innerhalb dieser Verzögerungsphase das Audiosignal nochmals geprüft werden, ob es tatsächlich weitergegeben werden soll. Eine weitere, bevorzugte Alternative für eine Anwendung wird nachfolgend dargestellt.

Allerdings ist eine dauerhafte Signalverzögerung in vielen Anwendungsbereichen nicht gewünscht oder sogar absolut zu vermeiden. Werden beispielsweise mehrere Verstärkervorrichtungen verwendet, führen insbesondere unterschiedliche Verzögerungswerte zu Phasenstörungen bei den verstärkten, ausgehenden Audiosignalen, die für Zuhörer unangenehm sind. Weiterhin kann auch eine dauerhafte Signalverzögerung bei einer einzelnen Verstärkervorrichtung bei den Zuhörern unangenehm wahrgenommen werden, da z. B. das optische Bild eines Akteurs nicht mit der Audioübertragung seiner Stimme übereinstimmt. Besonders kritisch sind zusätzlich Irritationen von Akteuren oder Interpreten selbst, die über die Verstärkervorrichtung verstärkt werden, wenn diese Verzögerungen bei Sprache oder Gesang erdulden müssen.

Durch die erfindungsgemäße Ausgestaltung der Verstärkervorrichtung wird erreicht, dass zwar zunächst eine temporäre Signalverzögerung erlaubt ist, diese jedoch in der Anpassungsphase sofort oder unverzüglich abgebaut wird, sodass die Störungen durch den Verzögerungswert minimiert sind.

Eine besonders bevorzugte Ausführungsform der Erfindung betrifft ein Aktivieren der Verstärkereinrichtung. Ein derartiges Aktivieren erfolgt z. B. bei einem Grundanschalten der Verstärkereinrichtung oder bei einem Aktivieren der Verstärkereinrichtung aus einem Energiesparzustand, insbesondere aus einem Standbymodus und/oder aus einem Ruhemodus.

In dieser bevorzugten Anwendung weist die Steuerungseinrichtung ein Einschaltmodul zum Aktivieren der Verstärkereinrichtung und zugleich des Verzögerungsmoduls auf. Das Einschaltmodul wird durch ein ankommendes Audiosignal an der Eingangsschnittstelle getriggert und ist ausgebildet, die Verstärkereinrichtung und das Verzögerungsmodul als Reaktion auf das an der Eingangsschnittstelle eingehende Audiosignal insbesondere synchronisiert zueinander zu aktivieren. Das Einschaltmodul und das Verzögerungsmodul sind so ausgebildet, dass ein Startwert für den Verzögerungswert für die zeitliche Verzögerung des Audiosignals länger als die Dauer des Aktivierungsvorgangs der Verstärkereinrichtung gewählt ist, sodass das verzögerte Audiosignal die Verstärkereinrichtung erst nach dem Aktivierungsvorgang, also in einem verstärkungsbereiten Zustand erreicht.

Besonders bevorzugt wird das ankommende Audiosignal von dem Verzögerungsmodul zunächst zwischengespeichert. Zugleich wird die Verstärkereinrichtung durch das Einschaltmodul aktiviert. Sobald die Verstärkereinrichtung den Aktivierungsvorgang durchlaufen hat und aktiviert ist, wird das Audiosignal freigegeben und als verzögertes Audiosignal an die Verstärkereinrichtung übergeben. Die zeitliche Verzögerung zwischen Ankommen des Audiosignals und Übergabe des verzögerten Audiosignals an die Verstärkereinrichtung entspricht dem Startwert für den Verzögerungswert.

Der Vorteil des Zusammenspiels von Einschaltmodul und Verzögerungsmodul ist, dass - für den Fall, dass die Verstärkereinrichtung inaktiv geschalten ist - das Audiosignal zunächst zwischengespeichert wird, bis die Verstärkereinrichtung wieder aktiviert ist, und erst dann an die Verstärkereinrichtung weitergegeben wird. Diese Ausgestaltung stellt sicher, dass es zu keinem Informationsverlust kommen kann, da das verzögerte Audiosignal erst an die funktionsbereite Verstärkereinrichtung übergeben wird. Allerdings resultiert durch diese Ausgestaltung die zuvor angesprochene Signalverzögerung.

Diese wird in der Anpassungsphase, die sich vorzugsweise unmittelbar an den Aktivierungsvorgang anschließt, durch das Verzögerungsmodul automatisch und/oder selbsttätig abgebaut.

Bei einer bevorzugten schaltungstechnischen Ausbildung der Erfindung ist der Startwert kleiner als 80 Millisekunden, vorzugsweise kleiner als 60 Millisekunden und insbesondere kleiner als 40 Millisekunden ausgebildet. Dieser Verzögerungswert ist ausreichend, um die Zeitdauer für den Aktivierungsvorgang der Verstärkereinrichtung zu überbrücken.

Es ist besonders bevorzugt, dass der Endwert kleiner als 50 Prozent, vorzugweise kleiner als 30 Prozent und insbesondere kleiner als 10 Prozent des Startwerts ist oder insbesondere Null Sekunden beträgt. Dieser Ausprägung liegt die Überlegung zugrunde, dass der Verzögerungswert in der Anpassungsphase minimiert werden sollte. Allerdings ist es technisch vertretbar, wenn der Verzögerungswert nicht auf null Sekunden reduziert wird, sondern nur noch einen geringen Bruchteil des Startwerts beträgt.

Bei einer bevorzugten Ausbildungsform der Erfindung ist die Dauer für die Anpassungsphase zur Überführung des Verzögerungswerts von dem Startwert in den Endwert größer als eine Sekunde, vorzugsweise größer als fünf Sekunden und insbesondere größer als acht Sekunden bemessen. Alternativ oder ergänzend weist diese eine Dauer kleiner als 40 Sekunden, vorzugsweise kleiner als 30 Sekunden und insbesondere kleiner als 20 Sekunden auf. Das Verhältnis zwischen der Dauer der Anpassungsphase und dem Verzögerungswert ist so bemessen, dass das Rückfahren des Verzögerungswerts derart langsam passiert, dass die daraus resultierende Frequenzanhebung des Audiosignals für das menschliche Gehör nicht, nur kaum oder nicht störend wahrzunehmen ist. Die genannten Werte von dem Verzögerungswert und der Anpassungsphase erfüllen diese Voraussetzungen. Geht man zum Beispiel von einem benötigten Verzögerungswert von 20 Millisekunden aus, sollte die Zeit zum Erreichen der direkten oder unverzögerten Signaldurchleitung bei fünf bis zehn Sekunden liegen.

Bei einer besonders bevorzugten und technisch vorteilhaften Ausführungsform ist vorgesehen, dass die Verstärkereinrichtung einen Class-D-Verstärker (oder auch Klasse-D Verstärker genannt) umfasst oder als ein derartiger ausgebildet ist. Wie eingangs bereits erläutert, sind Class-D-Verstärker besonders energieeffizient, wenn diese Audiosignale verstärken. Aus diesem Grund werden Class-D-Verstärker auch bevorzugt bei Hochleitungsanwendungen eingesetzt.

Jedoch benötigen Class-D-Verstärker in Bereitschaft - das heißt eingeschaltet und ohne anliegendes Audiosignal - eine große Menge elektrischer Energie, welche im Wesentlichen durch Schaltverluste in der Verstärkereinrichtung beziehungsweise in dem Ausgangsfilter in Wärme umgewandelt wird. Geht man davon aus, dass zum Beispiel bei der Anwendung der Verstärkervorrichtung zur Beschallung eines Fußballstadions die Verstärkervorrichtung langfristig nur etwa fünf Prozent der Zeit im Spiel genutzt wird, geht während 95 Prozent der Betriebszeit die aufgenommene Energie verloren.

Um diese Bereitschaftsverluste zu minimieren, ist vorgesehen, dass die Verstärkervorrichtung, insbesondere die Verstärkereinrichtung nach einer gewissen Zeit, z. B. 15 min, ohne anliegendes Audiosignal in den Energiesparzustand geschickt wird. Das Aufwecken der Verstärkervorrichtung beziehungsweise der Verstärkereinrichtung aus dem Energiesparzustand benötigt jedoch für den Aktivierungsvorgang eine gewisse Zeitspanne, sodass es bislang nicht vertretbar war, die Verstärkervorrichtung beziehungsweise Verstärkereinrichtung während des Betriebs in den Energiesparzustand zu versetzen. Mit der Erfindung ist es nun möglich, die Verstärkervorrichtung beziehungsweise -einrichtung in den Energiesparzustand zu schicken und - bei Anliegen eines Audiosignals - wieder zu aktivieren, wobei die Zeitdauer für den Aktivierungsvorgang durch das Verzögerungsmodul kompensiert wird, indem das Audiosignal zunächst zwischengespeichert und damit um einen zeitlichen Verzögerungswert verzögert ausgegeben und nachfolgend in der Anpassungsphase der Verzögerungswert abgebaut wird.

Bei einer besonders bevorzugten konstruktiven Ausgestaltung der Erfindung weist der Class-D-Verstärker einen Pulsweitenmodulator und einen nachgeschaltetes Leistungsteil auf, wobei bei der Deaktivierung der Verstärkereinrichtung für den Energiesparzustand pulsweitenmodulierte Signale aus dem Pulsweitenmodulator von dem nachgeschalteten Leistungsteil getrennt sind, um Leistungsverluste zu vermeiden.

Bei einer bevorzugten Weiterbildung der Erfindung ist nach einem Ausgang des Class-D-Verstärkers eine Schalteinrichtung angeordnet, die zur Trennung des Ausgangs der Verstärkereinrichtung von einem nachgeschalteten Lautsprecher oder Lautsprecheranlage ausgebildet ist, sodass bei einer Trennung keine Störgeräusche während des Aktivierungsvorgangs von der Verstärkereinrichtung an den nachgeschalteten Lautsprecher übertragen werden.

Bei einem Überführen der Verstärkereinrichtung in den Energiesparzustand wird zunächst der Ausgang der Verstärkereinrichtung über zum Beispiel ein Relais als Schalteinrichtung von dem nachgeschalteten Lautsprecher getrennt. Nachfolgend folgt die Deaktivierung des Class-D-Verstärkers durch Sperrung der pulsweitenmodulierten Signale.

Bei einer Aktivierung der Verstärkereinrichtung wird nach dem Anliegen eines Audiosignals der Class-D-Verstärker durch Freigabe der pulsweitenmodulierten Signale wieder reaktiviert, sodass der Leistungsteil wieder zu Schalten beginnt. Sobald der Class-D-Verstärker wieder eingeschwungen ist, wird auch der Ausgang des Class-D-Verstärkers durch das Relais als Schalteinrichtung wieder aufgeschaltet. Diese verzögerte Aufschaltung ist vorteilhaft, um ein "Knacken" des Lautsprechers, verursacht durch das Einschwingen des Class-D-Verstärkers, zu verhindern.

Bei einer bevorzugten Realisierung der Erfindung ist die Steuereinrichtung als ein DSP (digital signal processor) ausgebildet oder umfasst diesen, wobei der DSP ausgebildet ist, während der Verzögerung das Audiosignal zwischen zu speichern. Beispielsweise kann die Speicherung in einer FIFO-Struktur erfolgen.

Ein weiterer Gegenstand der Erfindung betrifft ein Verfahren zum Aktivieren einer Verstärkervorrichtung, insbesondere der Verstärkervorrichtung, wie sie zuvor beschrieben wurde beziehungsweise nach einem der vorhergehenden Ansprüche, wobei sich die Verstärkervorrichtung zunächst in einem Energiesparzustand befindet und durch ein eingehendes Audiosignal aus dem Energiesparzustand aktiviert wird. Das Audiosignal wird während eines Aktivierungsvorgangs der Verstärkervorrichtung um einen Verzögerungswert verzögert, wobei nach dem Aktivierungsvorgang das verzögerte Audiosignal mit einem Startwert als Verzögerungswert verstärkt wird und wobei der Verzögerungswert in einer Anpassungsphase von dem Startwert auf einen kleineren Endwert oder auf null verringert wird, um das Audiosignal nach der Anpassungsphase unverzögert zu verstärken.

Weitere Merkmale, Vorteile und Wirkungen der Erfindung ergeben sich aus der nachfolgenden Beschreibung, bevorzugte Ausführungsbeispiele der Erfindung sowie der beigefügten Figuren. Dabei zeigen:
- Figur 1: ein schematisches Blockdiagramm einer Verstärkervorrichtung als ein Ausführungsbeispiel der Erfindung;
- Figur 2: die Verstärkereinrichtung in Figur 1 in einer möglichen Ausbildungsform;
- Figur 3: ein Diagramm zur Illustration des erfindungsgemäßen Verfahrens.

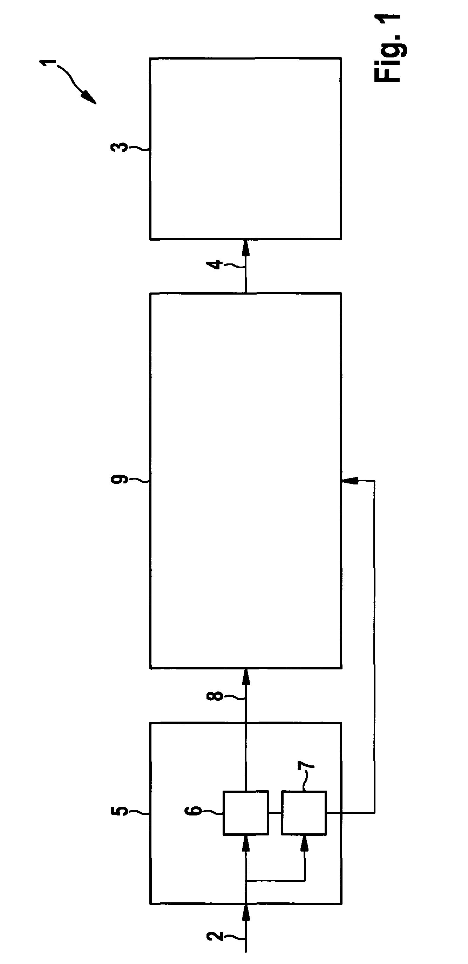

Die Figur 1 zeigt stark schematisiert in einem Blockdiagramm eine Verstärkervorrichtung 1 als ein Ausführungsbeispiel der Erfindung. Die Verstärkervorrichtung 1 ist dazu ausgebildet, ein eingehendes Audiosignal 2 zu verstärken und an einen oder mehrere Lautsprecher 3 als ein ausgehendes Audiosignal 4 auszugeben.

Das eingehende Audiosignal 2 kann beispielsweise von einem Mikrofon oder einer anderen Audioquelle kommen. Besonders bevorzugt ist das eingehende Audiosignal 2 ein Sprachsignal oder eine Sprachnachricht. Die Verstärkervorrichtung 1 ist beispielsweise zur Beschallung eines großen Bereichs, wie zum Beispiel eines Fußballstadions ausgebildet. Die Ausgangsleistung der Verstärkervorrichtung 1 ist z. B. größer als 100 Watt, insbesondere größer als 500 Watt und im Speziellen größer als 1000 Watt.

Die Verstärkervorrichtung 1 weist eine Steuerungseinrichtung 5 auf, welche ein Verzögerungsmodul 6 und ein Einschaltmodul 7 umfasst. Das Verzögerungsmodul 6 ist dazu ausgebildet, das eingehende Audiosignal 2 in ein aus der Steuerungseinrichtung 5 ausgehendes zeitlich verzögertes Audiosignal 8 zu überführen, welches einer nachgeschalteten Verstärkereinrichtung 9 zugeführt wird.

Das Einschaltmodul 7 ist dazu ausgebildet, das Verzögerungsmodul 6 zu steuern und die nachgeschaltete Verstärkereinrichtung 9 zu aktivieren. Eine Aktivierung der Verstärkereinrichtung 9 erfolgt beispielsweise, wenn die Verstärkervorrichtung 1 und insbesondere die Verstärkereinrichtung 9 in einen Energiesparzustand geschalten ist. Das Umschalten in einen Energiesparzustand kann beispielsweise erfolgen, wenn die Verstärkervorrichtung 1 beziehungsweise die Verstärkereinrichtung 9 für eine vorgebbare Zeitspanne nicht angesprochen wird, also zum Beispiel das eingehende Audiosignal 2 für die vorgebbare Zeitspanne unterhalb von einem Grenzwert liegt.

Durch den Energiesparzustand kann signifikant Energie bei dem Betrieb der Verstärkervorrichtung 1 eingespart werden. So gibt es viele Anwendungen, bei denen die Verstärkervorrichtung 1 über den Großteil der Betriebszeit nicht genutzt ist. Betrachtet man beispielsweise ein typisches Fußballspiel, so ist die Verstärkervorrichtung 1 zur Beschallung des Stadions üblicherweise zu weniger als fünf Prozent der Gesamtzeit am Tage eines Fußballspiels genutzt, sodass die Verstärkervorrichtung 1 theoretisch 95 Prozent der Betriebszeit in den Energiesparzustand versetzt werden kann. So ist es z.B. denkbar, dass die Verstärkervorrichtung 1 bereits am Morgen "hochgefahren" und getestet, jedoch erst am Abend für die Beschallung das Fußballspiels verwendet wird. Es ist auch möglich, dass die Verstärkervorrichtung an allen Tagen, d.h. 365 Tage pro Jahr, aktiviert bleibt, jedoch nur z.B. alle 3 Tage für 5h benötigt wird.

Technisch betrachtet benötigt jedoch die Verstärkervorrichtung 1 bzw. die Verstärkereinrichtung 9 in einem Aktivierungsvorgang eine gewisse Zeitspanne, um von dem Energiesparzustand in den Betriebszustand überführt zu werden, um zum Beispiel Einschwingvorgänge bei der Aktivierung durchzuführen. Somit ist es nicht praktikabel, wenn sich die Verstärkervorrichtung 1 in einem Energiesparzustand befindet, ein eingehendes Audiosignal 2 unverzögert an die Verstärkereinrichtung 9 weiterzugeben. Da die Verstärkereinrichtung 9 noch nicht verstärkungsbereit ist, würde ein Anfangsabschnitt des eingehenden Audiosignals 2 nicht verstärkt werden, sodass ein Informationsverlust eintreten würde.

Um diesen Effekt zu vermeiden, ist die Steuerungseinrichtung 5 ausgebildet, bei einem eingehenden Audiosignal 2 über das Einschaltmodul 7 die Verstärkereinrichtung 9 zu aktivieren, sodass diese von dem Energiesparzustand in einen Betriebszustand überführt wird. Um den Informationsverlust zu Beginn des Audiosignals zu umgehen, wird durch das Verzögerungsmodul 6 das eingehende Audiosignal 2 um einen Verzögerungswert verzögert, sodass das verzögerte Audiosignal 8 erst an die Verstärkereinrichtung 9 gelangt, wenn sich diese im Betriebszustand befindet.

Nachdem eine derartige Verzögerung jedoch auch Nachteile mit sich bringt, ist vorgesehen, dass das Verzögerungsmodul 6 die Verzögerung in einer Anpassungsphase von einem anfänglichen Startwert selbstständig und/oder automatisch zu einem Endwert überführt und dadurch verringert. Beträgt beispielsweise der Startwert für den Verzögerungswert 20 Millisekunden, so wird während einer Anpassungsphase über fünf bis zehn Sekunden dieser Startwert auf einen Endwert von z. B. 0 Millisekunden zurückgefahren.

Das langsame Zurückfahren des Verzögerungswertes stellt dabei einen Kompromiss zwischen den Nachteilen, die sich durch die Verzögerung ergeben und etwaiger Frequenzerhöhungen, die durch das Zurückfahren des Verzögerungswerts entstehen, dar. So muss das eingehende Audiosignal 2, um die Verzögerung zu kompensieren, in der Anpassungsphase als das verzögerte Audiosignal 8 schneller als in Echtzeit an die Verstärkereinrichtung 9 ausgegeben werden, was zu einer Frequenzerhöhung in dem verzögerten Audiosignal 9 führt. Die Verringerung des Verzögerungswertes ist somit bildlich vergleichbar mit dem zu schnellen Abspielen einer Schallplatte, wobei es ebenfalls zu Frequenzerhöhungen kommt. Die gewählten Größen stellen einen technisch sinnvollen Kompromiss dar.

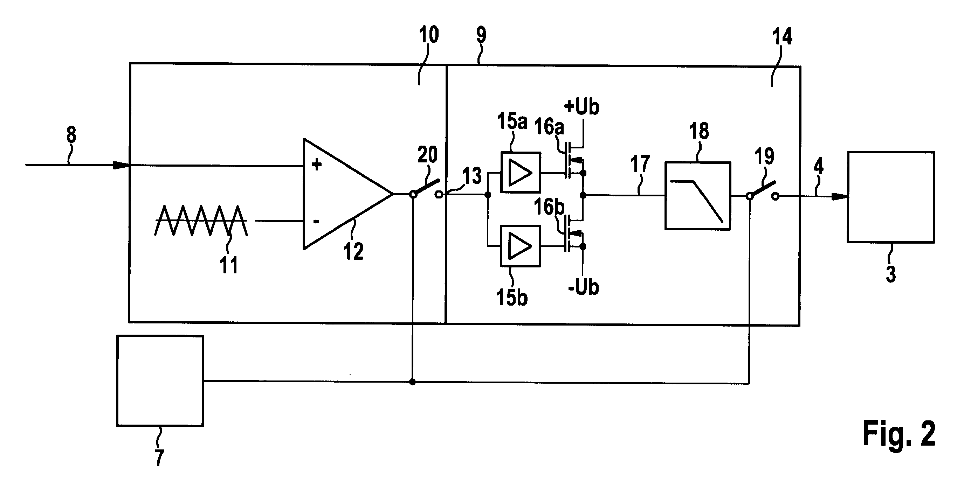

Die Figur 2 zeigt ebenfalls in einer Blockdarstellung die Verstärkereinrichtung 9, wobei zu erkennen ist, dass die Verstärkereinrichtung 9 als ein sogenannter Class-D-Verstärker (D-Klasse-Verstärker) ausgebildet ist. Auf der linken Seite ist der Eingang der Verstärkereinrichtung 9 dargestellt, in den das verzögerte Audiosignal 8 eingeht. Das verzögerte Audiosignal 8 wird zunächst in einen Pulsweitenmodulator 10 geführt, welcher in diesem Ausführungsbeispiel das verzögerte Audiosignal 8 und ein Sägezahnsignal 11 in einem Komparator 12 zusammenführt, der ein unverstärktes pulsweitenmoduliertes Signal 13 ausgibt.

Das unverstärkte pulsweitenmodulierte Signal 13 wird in eine Leistungsstufe 14 geleitet, welche als eine Halbbrücke ausgebildet ist, wobei das unverstärkte pulsweitenmodulierte Signal 13 auf zwei Zweige aufgeteilt wird und zunächst in Treiber 15 a, b geführt wird. Diese erzeugen Gatesignale für MOSFETS 16 a, b, welche jeweils ein verstärktes Signal erzeugen. Die verstärkten Signale werden wieder zusammengeführt, sodass am Ausgang der Leistungsstufe 14 ein verstärktes pulsweitenmodulierte Signal 17 vorliegt. Dieses Signal wird nachfolgend durch einen Tiefpass 18 geleitet, sodass das ausgehende Audiosignal 4 als verstärktes Audiosignal vorliegt. Ein derartiger Aufbau ist als Class-D-Verstärker ausreichend bekannt.

Um die Verstärkereinrichtung 9 in den Energiesparmodus zu versetzen, weist diese eine Schalteinrichtung 19, welche das das ausgehende Audiosignal 4 von dem nachgeschalteten Lautsprecher 3 trennt, sowie eine Signaleinrichtung 20 auf, welche ebenfalls als Schalter ausgebildet ist, und welche das unverstärkte pulsweitenmodulierte Signal 13 von der Leistungsstufe 14 trennt. Insbesondere kann die Signaleinrichtung 20 auch als ein UND-Gatter mit der gleichen Funktion ausgebildet sein.

Die Schalteinrichtung 19 und die Signaleinrichtung 20 werden durch das Einschaltmodul 7 geschaltet, um die Verstärkereinrichtung 9 von dem Energiesparzustand in den Betriebszustand zu überführen.

In dem Energiesparzustand sind die Schalteinrichtung 19 sowie die Signaleinrichtung 20 geöffnet. Die geöffnete Signaleinrichtung 19 hat den technischen Effekt, dass das unverstärkte pulsweitenmodulierte Signal 13 nicht an die Leistungsstufe 14 übertragen wird, sodass diese keine Energie zur Verstärkung aufwenden muss.

Wird die Verstärkereinrichtung 9 von dem Energiesparzustand in den Betriebszustand überführt, so wird zunächst die Signaleinrichtung 20 geschlossen, sodass das unverstärkte pulsweitenmodulierte Signal 13 an die Leistungsstufe 14 übertragen wird. Dieses benötigt eine gewisse Zeit für Einschwingvorgänge. Sobald sich ohne anliegendes verzögertes Audiosignal 8 hinter dem Tiefpass 18 ein Signalpegel von 0 Volt eingeschwungen hat, wird die Schalteinrichtung 19 geschlossen, sodass die Verbindung zu dem Lautsprecher 3 hergestellt ist. Die Schalteinrichtung 19 hat den Vorteil, dass etwaige auftretende Störgeräusche beim Einschwingen der Leistungsstufe 14 nicht an den Lautsprecher 3 übertragen werden. Nach dem Schließen der Schalteinrichtung 19 ist die Verstärkereinrichtung 9 in dem Betriebszustand und kann das dann eingehende, verzögerte Audiosignal 8 verstärken.

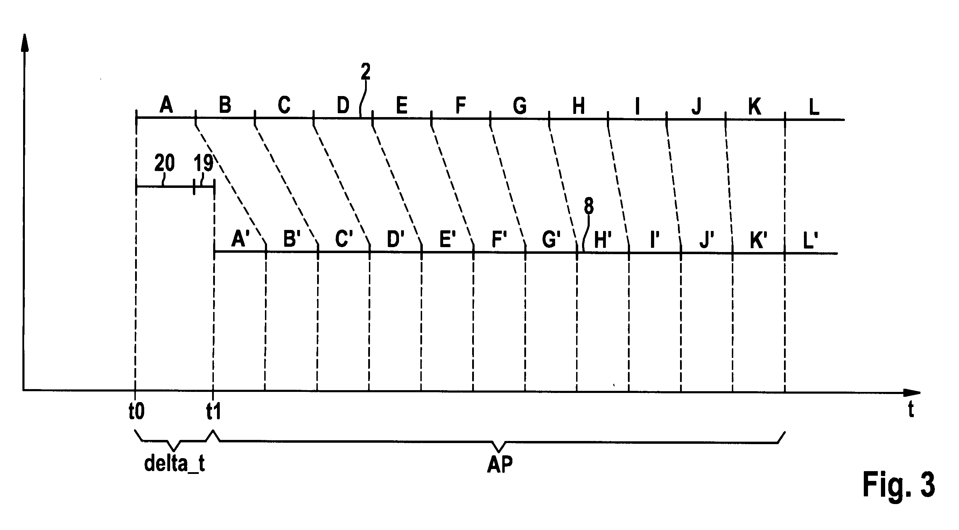

Die Figur 3 zeigt stark schematisiert ein Zeitdiagramm zur Illustration des erfindungsgemäßen Verfahrens, wie dies auf der Verstärkervorrichtung 1 umgesetzt wird.

Zunächst befindet sich die Verstärkervorrichtung 1, insbesondere die Verstärkereinrichtung 9, bis zu einem Zeitpunkt t0 in dem Energiesparzustand. Zu dem Zeitpunkt t0 wird am Eingang der Steuerungseinrichtung 5 das eingehende Audiosignal 2 angelegt. Das eingehende Audiosignal 2 ist entlang der Zeitachse t in Abschnitte A... L unterteilt und repräsentiert ein Audiosignal, welches beispielsweise als eine Sprachdurchsage ausgebildet ist, die diese Buchstaben vorliest.

Zeitgleich mit dem Eingang des eingehenden Audiosignals 2, also zum Zeitpunkt t0, wird durch das Einschaltmodul 7 die Verstärkereinrichtung 9 vom Energiesparzustand in den Betriebszustand überführt. Hierzu wird zunächst die Signaleinrichtung 20 geschlossen und nachfolgend die Schalteinrichtung 19 ebenfalls geschlossen. Zu einem Zeitpunkt t1 liegt somit die Verstärkereinrichtung 9 in dem Betriebszustand vor. Die zeitliche Differenz delta_t zwischen t0 und t1 entspricht der Zeit für den Aktivierungsvorgang des Verstärkereinrichtung 9 und beträgt z.B. 20ms.

Zeitgleich verzögert das Verzögerungsmodul 6 das eingehende Audiosignal 2, sodass das verzögerte Audiosignal 8 um mindestens oder genau den Verzögerungswert delta_t verzögert ist. Der Wert delta_t bildet einen Startwert für den Verzögerungswert. Das verzögerte Audiosignal 8 wird - wie bereits beschrieben - aufgrund der Verzögerung informationsverlustfrei von der Verstärkereinrichtung 9 verstärkt.

Um den Verzögerungswert delta_t von dem Startwert auf einen Endwert, insbesondere auf null zurückzufahren, wird der Verzögerungswert delta_t während einer Anpassungsphase AP von z.B. 5s bis 10s ständig reduziert. Die Anpassungsphase AP schließt sich unmittelbar an den Aktivierungsvorgang zum Zeitpunkt t1 an. Während zwischen dem Audiosignalabschnitten A und A' ein Verzögerungswert vorherrscht, der dem Startwert delta_t entspricht, ist beispielsweise bei den Audioabschnitten G und G' der Verzögerungswert bereits auf 50 Prozent des Startwerts gefallen. Bei dem Audioabschnitt L - L' ist der Verzögerungswert auf den Endwert, in diesem Fall auf null Sekunden zurückgefahren. Nach der Anpassungsphase AP wird das eingehende Audiosignal 2 somit unverzögert und unverzerrt an die Verstärkereinrichtung 9 weitergegeben. Die Verstärkervorrichtung 1 arbeitet dann im normalen Betriebszustand.

## Patentansprüche

1. Verstärkervorrichtung (1)
mit einer Steuerungseinrichtung (5), wobei die Steuerungseinrichtung (5) eine Eingangsschnittstelle für ein Audiosignal (2) aufweist,
mit einer der Steuerungseinrichtung (5) nachgeschalteten Verstärkereinrichtung (9) zur Verstärkung des Audiosignals (2,8),
wobei die Steuerungseinrichtung (5) ein Verzögerungsmodul (6) aufweist, wobei das Verzögerungsmodul (6) ausgebildet ist, das Audiosignal (2) um einen Verzögerungswert (delta_t) verzögert an die Verstärkereinrichtung (9) weiterzugeben und in einer Anpassungsphase (AP) den Verzögerungswert (delta_t) automatisch und/oder selbsttätig von einem Startwert (delta_t) zu einem Endwert zu verringern,
**dadurch gekennzeichnet, dass**
die Steuerungseinrichtung (5) ein Einschaltmodul (7) zum Aktivieren der Verstärkereinrichtung (9) und zum Steuern des Verzögerungsmoduls (6) aufweist, wobei das Einschaltmodul (7) ausgebildet ist, die Verstärkereinrichtung (9) als Reaktion auf ein eingehendes Audiosignal (2) an der Eingangsschnittstelle zu aktivieren, wobei der Startwert für die Verzögerung des Audiosignals (2) gleich lang oder länger als die Dauer eines Aktivierungsvorgangs der Verstärkereinrichtung (9) gewählt ist, so dass das verzögerte Audiosignal (8) die Verstärkereinrichtung (9) erst nach dem Aktivierungsvorgang (AP) erreicht.

2. Verstärkervorrichtung (1) nach Anspruch 1, **dadurch gekennzeichnet, dass** der Startwert (delta_t) kleiner als 80 ms, vorzugsweise kleiner als 60 ms und insbesondere kleiner als 40 ms gewählt ist.

3. Verstärkervorrichtung (1) nach einem der vorhergehenden Ansprüche, **dadurch gekennzeichnet, dass** der Endwert kleiner als 50%, vorzugsweise kleiner als 30% und insbesondere kleiner als 10% des Startwerts (delta_t) oder 0 s ist.

4. Verstärkervorrichtung (1) nach einem der vorhergehenden Ansprüche, **dadurch gekennzeichnet, dass** die Überführung des Verzögerungswerts von dem Startwert (delta_t) in den Endwert in der Anpassungsphase (AP) mit einer Dauer größer als 1 s, vorzugsweise größer als 5s und insbesondere größer als 8s erfolgt und/oder mit einer Dauer kleiner als 40s, vorzugsweise kleiner als 30s und insbesondere kleiner als 20s erfolgt.

5. Verstärkervorrichtung (1) nach einem der vorhergehenden Ansprüche, **dadurch gekennzeichnet, dass** die Verstärkereinrichtung (9) einen Class-D-Verstärker umfasst.

6. Verstärkervorrichtung (1) nach Anspruch 5, **dadurch gekennzeichnet, dass** der Class-D-Verstärker auf einen Energiesparzustand schaltbar ist, wobei das Einschaltmodul (7) zum Aktivieren des Class-D-Verstärkers aus dem Energiesparzustand ausgebildet ist.

7. Verstärkervorrichtung (1) nach Anspruch 5 oder 6, **dadurch gekennzeichnet, dass** nach einem Ausgang des Class-D Verstärkers eine Schalteinrichtung (19) angeordnet ist, die zur Trennung des Ausgangs des Class-D-Verstärkers von einem nachgeschalteten Lautsprecher (3) in dem Energiesparzustand ausgebildet ist, so dass nach einer Trennung keine Störgeräusche während des Aktivierungsvorgangs von dem Class-D-Verstärker an den Lautsprecher (3) übertragen werden.

8. Verstärkervorrichtung (1) nach einem der vorhergehenden Ansprüche, **dadurch gekennzeichnet, dass** die Steuereinrichtung (5) als ein DSP ausgebildet ist oder diesen umfasst, wobei der DSP ausgebildet ist, während der Verzögerung das Audiosignal (2) zwischen zu speichern.

9. Verfahren zum Aktivieren einer Verstärkervorrichtung (1), insbesondere der Verstärkervorrichtung (1) nach einem der vorhergehenden Ansprüche, **dadurch gekennzeichnet, dass** die Verstärkervorrichtung (1) durch ein eingehendes Audiosignal (2) aus einem Energiesparzustand geweckt wird, dass das Audiosignal (2) während des Aktivierungsvorgangs um einen Verzögerungswert (delta_t) verzögert wird, wobei nach dem Aktivierungsvorgang das verzögerte Audiosignal (8) mit einem Startwert (delta_t) als Verzögerungswert verstärkt wird, wobei der Verzögerungswert in einer Anpassungsphase (AP) von dem Startwert (delta_t) auf einen kleineren Endwert oder auf Null verringert wird, so dass das Audiosignal nach der Anpassungsphase (AP) unverzögert verstärkt wird.

10. Steuerungseinrichtung (5), insbesondere für eine Verstärkervorrichtung (1) nach einem der Ansprüche 1 bis 8, wobei die Steuerungseinrichtung (5) eine Eingangsschnittstelle für ein Audiosignal (2) und eine Ausgangsschnittstelle für eine Ausgabe des Audiosignals (2, 8) an eine nachgeschaltete Verstärkereinrichtung (9) zur Verstärkung des Audiosignals (2, 8) aufweist,
wobei die Steuerungseinrichtung (5) ein Verzögerungsmodul (6) aufweist, wobei das Verzögerungsmodul (6) ausgebildet ist, das Audiosignal (2) um einen Verzögerungswert (delta_t) verzögert an die Verstärkereinrichtung (9) weiterzugeben und in einer Anpassungsphase (AP) den Verzögerungswert (delta_t) automatisch und/oder selbsttätig von einem Startwert (delta_t) zu einem Endwert zu verringern,
**dadurch gekennzeichnet, dass**
die Steuerungseinrichtung (5) ein Einschaltmodul (7) zum Aktivieren der Verstärkereinrichtung (9) und zum Steuern des Verzögerungsmoduls (6) aufweist, wobei das Einschaltmodul (7) ausgebildet ist, die Verstärkereinrichtung (9) als Reaktion auf ein eingehendes Audiosignal (2) an der Eingangsschnittstelle zu aktivieren, wobei der Startwert für die Verzögerung des Audiosignals (2) gleich lang oder länger als die Dauer eines Aktivierungsvorgangs der Verstärkereinrichtung (9) gewählt ist, so dass das verzögerte Audiosignal (8) die Verstärkereinrichtung (9) erst nach dem Aktivierungsvorgang (AP) erreicht.

## Claims

1. Amplifier apparatus (1)
having a control device (5), wherein the control device (5) has an input interface for an audio signal (2),
having an amplifier device (9), which is connected downstream of the control device (5), for amplifying the audio signal (2, 8),
wherein the control device (5) has a delay module (6), wherein the delay module (6) is designed to forward the audio signal (2) to the amplifier device (9) in a manner delayed by a delay value (delta_t) and, in an adaptation phase (AP), to automatically and/or independently decrease the delay value (delta_t) from a starting value (delta_t) to a final value,
**characterized in that**
the control device (5) has a switch-on module (7) for activating the amplifier device (9) and for controlling the delay module (6), wherein the switch-on module (7) is designed to activate the amplifier device (9) as a reaction to an incoming audio signal (2) on the input interface, wherein the starting value for the delay in the audio signal (2) is chosen to be of the same length as or longer than the duration of an activation process for the amplifier device (9), as a result of which the delayed audio signal (8) reaches the amplifier device (9) only after the activation process (AP).

2. Amplifier apparatus (1) according to Claim 1, **characterized in that** the starting value (delta_t) is chosen to be less than 80 ms, preferably less than 60 ms and particularly less than 40 ms.

3. Amplifier apparatus (1) according to either of the preceding claims, **characterized in that** the final value is less than 50%, preferably less than 30% and particularly less than 10% of the starting value (delta_t) or 0 s.

4. Amplifier apparatus (1) according to one of the preceding claims, **characterized in that** the delay value is transferred from the starting value (delta_t) to the final value in the adaptation phase (AP) with a duration of greater than 1 s, preferably greater than 5 s and particularly greater than 8 s and/or with a duration of less than 40 s, preferably less than 30 s and particularly less than 20 s.

5. Amplifier apparatus (1) according to one of the preceding claims, **characterized in that** the amplifier device (9) comprises a class-D amplifier.

6. Amplifier apparatus (1) according to Claim 5, **characterized in that** the class-D amplifier can be switched to an energy-saving state, wherein the switch-on module (7) is designed to activate the class-D amplifier from the energy-saving state.

7. Amplifier apparatus (1) according to Claim 5 or 6, **characterized in that** an output of the class-D amplifier has a switching device (19) arranged downstream of it that is designed to isolate the output of the class-D amplifier from a downstream loudspeaker (3) in the energy-saving state, so that following isolation no disturbing noise is transmitted from the class-D amplifier to the loudspeaker (3) during the activation process.

8. Amplifier apparatus (1) according to one of the preceding claims, **characterized in that** the control device (5) is in the form of a DSP or comprises the latter, wherein the DSP is designed to buffer-store the audio signal (2) during the delay.

9. Method for activating an amplifier apparatus (1), particularly the amplifier apparatus (1) according to one of the preceding claims, **characterized in that** the amplifier apparatus (1) is woken from an energy-saving state by an incoming audio signal (2), **in that** the audio signal (2) is delayed by a delay value (delta_t) during the activation process, wherein the activation process is followed by the delayed audio signal (8) being amplified with a starting value (delta_t) as delay value, wherein the delay value is decreased from the starting value (delta_t) to a smaller final value or to zero in an adaptation phase (AP), so that the audio signal is amplified in undelayed form after the adaptation phase (AP).

10. Control device (5), particularly for an amplifier apparatus (1) according to one of Claims 1 to 8, wherein the control device (5) has an input interface for an audio signal (2) and an output interface for output of the audio signal (2, 8) to a downstream amplifier device (9) for amplifying the audio signal (2, 8),
wherein the control device (5) has a delay module (6), wherein the delay module (6) is designed to forward the audio signal (2) to the amplifier device (9) in a manner delayed by a delay value (delta_t) and, in an adaptation phase (AP), to automatically and/or independently decrease the delay value (delta_t) from a starting value (delta_t) to a final value,
**characterized in that**
the control device (5) has a switch-on module (7) for activating the amplifier device (9) and for controlling the delay module (6), wherein the switch-on module (7) is designed to activate the amplifier device (9) as a reaction to an incoming audio signal (2) on the input interface, wherein the starting value for the delay in the audio signal (2) is chosen to be of the same length as or longer than the duration of an activation process for the amplifier device (9), as a result of which the delayed audio signal (8) reaches the amplifier device (9) only after the activation process (AP).

## Revendications

1. Dispositif amplificateur (1)
comportant un dispositif de commande (5), dans lequel le dispositif de commande (5) comprend une interface d'entrée destinée à un signal audio (2),
comportant un dispositif amplificateur (9) connecté en aval du dispositif de commande (5) pour amplifier le signal audio (2, 8),
dans lequel le dispositif de commande (5) comprend un module de retard (6), dans lequel le module de retard (6) est conçu pour réacheminer le signal audio (2) vers le dispositif amplificateur (9) retardé d'une valeur de retard (delta_t) et pour réduire automatiquement et/ou de manière autonome la valeur de retard (delta_t) lors d'une phase d'adaptation (AP) d'une valeur de départ (delta_t) à une valeur finale,
**caractérisé en ce que** le dispositif de commande (5) comprend un module d'activation (7) destiné à activer le dispositif amplificateur (9) et à commander le module de retard (6), dans lequel le module d'activation (7) est conçu pour activer le dispositif amplificateur (9) en réaction à la fourniture en entrée d'un signal audio (2) à l'interface d'entrée, dans lequel la valeur de départ pour le retard du signal audio (2) est sélectionnée de manière à être de même longueur ou de longueur supérieure à la durée d'un processus d'activation du dispositif amplificateur (9), de manière à ce que le signal audio retardé (8) n'atteigne le dispositif amplificateur (9) qu'après le processus d'activation (AP).

2. Dispositif amplificateur (1) selon la revendication 1, **caractérisé en ce que** la valeur de départ (delta_t) est sélectionnée de manière à être inférieure à 80 ms, de préférence inférieure à 60 ms et plus particulièrement, inférieure à 40 ms.

3. Dispositif amplificateur (1) selon l'une quelconque des revendications précédentes, **caractérisé en ce que** la valeur finale est inférieure à 50 %, de préférence, inférieure à 30 % et plus particulièrement, inférieure à 10 % de la valeur de départ (delta_t) ou est de 0 s.

4. Dispositif amplificateur (1) selon l'une quelconque des revendications précédentes, **caractérisé en ce que** la transition de la valeur de retard de sa valeur de départ (delta_t) à sa valeur finale lors de la phase d'adaptation (AP) s'effectue sur une durée supérieure à 1 s, de préférence, supérieure à 5 s, et plus particulièrement, supérieure à 8 s et/ou s'effectue sur une durée inférieure à 40 s, de préférence, inférieure à 30 s, et plus particulièrement, inférieure à 20 s.

5. Dispositif amplificateur (1) selon l'une quelconque des revendications précédentes, **caractérisé en ce que** le dispositif amplificateur (9) comprend un amplificateur de classe D.

6. Dispositif amplificateur (1) selon la revendication 5, **caractérisé en ce que** l'amplificateur de classe D peut être commuté dans un état d'économie d'énergie, dans lequel le module d'activation (7) est conçu pour activer l'amplificateur de classe D à partir de l'état d'économie d'énergie.

7. Dispositif amplificateur (1) selon la revendication 5 ou 6, **caractérisé en ce qu'**un dispositif de commutation (19) est disposé en aval d'une sortie de l'amplificateur de classe D, lequel dispositif de commutation est destiné à séparer la sortie de l'amplificateur de classe D d'un haut-parleur (3) connecté en aval dans l'état d'économie d'énergie, de manière à ce qu'après une séparation, aucun bruit parasite ne soit transmis au haut-parleur (3) pendant le processus d'activation de l'amplificateur de classe D.

8. Dispositif amplificateur (1) selon l'une quelconque des revendications précédentes, **caractérisé en ce que** le dispositif de commande (5) est réalisé sous la forme d'un DSP ou comprend ce dernier, dans lequel le DSP est conçu pour stocker en tampon le signal audio (2) pendant le processus de retard.

9. Procédé d'activation d'un dispositif amplificateur (1), notamment du dispositif amplificateur (1) selon l'une quelconque des revendications précédentes, **caractérisé en ce que** le dispositif amplificateur (1) est sorti d'un état d'économie d'énergie par un signal audio (2) fourni en entrée, **en ce que** le signal audio (2) est retardé d'une valeur de retard (delta_t) pendant le processus d'activation, dans lequel le signal audio retardé (8) est amplifié avec une valeur de retard égale à une valeur de départ (delta_t) après le processus d'activation, dans lequel la valeur de retard est réduite lors d'une phase d'adaptation (AP) de la valeur de départ (delta_t) à une valeur finale plus petite ou nulle, de manière à ce que le signal audio soit amplifié sans être retardé après la phase d'adaptation (AP).

10. Dispositif de commande (5), notamment destiné à un dispositif amplificateur (1) selon l'une quelconque des revendications 1 à 8, dans le quel le dispositif de commande (5) comporte une interface d'entrée destinée à un signal audio (2) et une interface de sortie destinée à la fourniture en sortie du signal audio (2, 8) à un dispositif amplificateur (9) connecté en aval destiné à amplifier le signal audio (2, 8),
dans lequel le dispositif de commande (5) comporte un module de retard (6), dans lequel le module de retard (6) est conçu pour réacheminer le signal audio (2) retardé d'une valeur de retard (delta_t) vers le dispositif amplificateur (9) et pour réduire automatiquement et/ou de manière autonome la valeur de retard (delta_t) d'une valeur de départ (delta_t) à une valeur finale lors d'une phase d'adaptation (AP), **caractérisé en ce que** le dispositif de commande (5) comprend un module d'activation (7) destiné à activer le dispositif amplificateur (9) et à commander le module de retard (6), dans lequel le module d'activation (7) est conçu pour activer le dispositif amplificateur (9) en réaction à la fourniture en entrée d'un signal audio (2) à l'interface d'entrée, dans lequel la valeur de départ pour le retard du signal audio (2) est sélectionnée de manière à être de même longueur ou de longueur supérieure à la durée d'un processus d'activation du dispositif amplificateur (9), de manière à ce que le signal audio retardé (8) n'atteigne le dispositif amplificateur (9) qu'après le processus d'activation (AP).
